(19) Europäisches Patentamt
European Patent Office
Office européen des brevets

(11) Publication number : **0 520 654 A1**

# (12) EUROPEAN PATENT APPLICATION

(21) Application number : **92305400.1**

(51) Int. Cl.$^5$ : **G03F 7/004**

(22) Date of filing : **12.06.92**

(30) Priority : **21.06.91 US 719891**

(43) Date of publication of application :
**30.12.92 Bulletin 92/53**

(84) Designated Contracting States :
**BE CH DE FR GB IT LI**

(71) Applicant : **HOECHST CELANESE CORPORATION**
**Route 202-206 North**
**Somerville, N.J. 08876 (US)**

(72) Inventor : **Chatterjee, Subhankar**
**42 Overlook Drive**
**Clinton, New Jersey 08809 (US)**

(74) Representative : **De Minvielle-Devaux, Ian Benedict Peter et al**
**CARPMAELS & RANSFORD 43, Bloomsbury Square**
**London WC1A 2RA (GB)**

(54) **Deep UV light sensitive positive photoresist compositions.**

(57) Positive photoresist compositions are disclosed, which comprise an admixture of :
a) 1 to 25% of a latent photoacid ;
b) 10 to 40% of a film forming polymer ;
c) 1 to 40% of an organic additive having the structural formula :

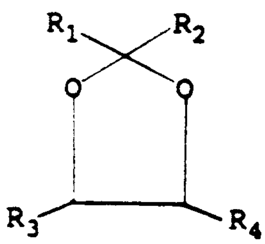

d) a suitable solvent.
A method for producing a semiconductor device by coating a substrate with the positive photoresist composition is also disclosed.

EP 0 520 654 A1

## FIELD OF INVENTION

The invention relates to photoresist compositions suitable for deep UV and excimer laser lithography. These compositions provide high resolution, high contrast and high sensitivity in the deep UV (wavelength of 250-300 nm), mid-UV (wave-length of 300-350 nm) or conventional UV (wavelength of 350-450 nm) exposure bands and are also suitable for exposure at wavelengths commonly associated with excimer laser sources (248, 308 nm) or for exposure by X-radiation.

## BACKGROUND OF THE INVENTION

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

There are two types of photoresist compositions, negative-working and positive-working. When negative-working photoresist compositions are exposed image-wise to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, the now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Presently available resists usually have one or more drawbacks. For example, most negative acting resists have limited resolution because they swell upon development or positive acting novolac resin based resists which are formulated from materials that are opaque at the shorter wavelengths needed for high resolution work, or are very insensitive as in the case of positive acting, polymethyl methacrylate based resists.

Processes have been developed to circumvent these problems (multi-level resist), but they are complex and require an increase in the number of steps per device layer. An ideal resist would be a single layer which could be exposed with deep UV light (200 to 300 nm) (DUV), X-rays, or electron beam radiation.

High sensitivity is also an essential property of a high resolution resist. The economics of semiconductor device manufacture require high throughput. This means that the time taken to expose each wafer must be minimized. As a result, the exposure energy per unit area of resist is constrained. Furthermore, some exposure tools have less total energy available in the bands used to achieve high resolution exposure bands. This further reduces the energy available at the wafer surface.

In order to solve the "throughput" problem, the concept of "chemical amplification" was introduced by Wilson et al. at IBM (C. G. Wilson, H. Ito, J. M. Frechet, T. G. Tessier and F. M. Houlihan, J. Electrochem, Soc. 1986, Vol. 133 (1), pages 181-187). In a chemical amplification scheme, the photogenerated acid catalytically

deblocks a protective group from a hydroxy substituted or imide substituted polymer. The protected polymer is lipophilic in nature and hence is soluble in nonpolar solvents. However, the deprotected polymer is a very hydrophilic material that is soluble in aqueous base and other polar solvents. Therefore radiation induced difference in solubility can be exploited to produce either positive or negative tone patterns of the mask depending on the polarity of the developing solvent. The protective group can be an ester, ether, formyl or carbonate. The t-butylcarbonate group has turned out to be a particularly attractive protective group because of its thermolysis characteristics and ease of synthesis. The key requirement for chemical amplification step is the availability of a hydrogen on a carbon alpha to the site of carbonium ion formation which can undergo elimination to liberate a proton ($H^+$) during the post exposure bake step. This elimination reaction is crucial to the catalytic cycle since the regenerated acid can lead to further deblocking of the protective groups, typical turnover rates (i.e. the catalytic chain length) for each acid molecule in a working resist formulation are in 800-1200 range. However, the deprotection and turnover rate are critically dependent on post-exposure bake temperature, time and method of bake.

The "metal lift-off method" is used to produce narrow lines of metal on a surface by first creating a pattern in a positive photoresist and then depositing metal over the pattern by evaporation. The photoresist film is removed by a solvent, leaving the desired lines of metal on the original substrate. However, if the walls of the pattern are covered with metal, the photoresist cannot be dissolved and consequently methods have been developed to create a profile -which prevents the walls from being coated with metal. Viewed from above, the top of the photoresist film should overhang the walls below so that they are shaded from metal deposited from above.

Such "T-shaped" or overhang profiles are normally a problem to be avoided in manufacturing semiconductor devices by methods other than the "metal lift-off method". Ironically, however, with protected polymer systems used in the chemical amplification method for deep UV lithography, formation of such "T-shaped" profiles is a typical problem. Extreme care must be taken to remove the environmental contaminants, e.g. bases. Presence of airborne bases in a typical manufacturing environment may neutralize the photogenerated acid at the surface of the exposed wafer (before post-exposure bake) thereby preventing deblocking reaction to take place during post-exposure bake steps. Therefore, the surface of the processed wafer remain protected which acts as a "surface skin" during the development step in aqueous alkali.

After exposure to the appropriate wavelength of actinic radiation or laser, the photoresist composition under the surface skin in the exposed areas is dissolved during development. The surface skin in the exposed areas also breaks away from the unexposed areas. Because the rate at which the resist in the exposed area dissolves is much faster than the rate at which the surface skin breaks away from the unexposed surface, T-topping results. In severe cases, the surface skin in the exposed areas may not be able to break away from the surface in the unexposed areas during development and "channel" formation occurs, which is a common occurrence with deep UV photoresist formulations, especially at submicron levels.

Thus, in the normal processes for manufacturing semiconductor devices using photoresists, the occurrence of T-topping adversely affects the formation of sharp and precise patterns on the semiconductor substrate. This T-topping precludes the formation of lithographic images having sharp vertical walls, particularly with resolution less than 1.0 micron.

Air borne bases that can cause the neutralization of the photogenerated acid at the resist surface may be generated by a wide variety of commonly used materials. Thus, trace amounts of environmental contaminants such as volatile amines can be derived from such things as fresh paint on a laboratory wall. These effects can be minimized by storing and processing the photoresist coated wafers in purified air that has passed through high efficiency carbon filters. Another solution is the use of overcoat materials for the photoresist which isolate the photoresist surface from such environmental contaminants. However, these approaches require additional processing steps, raw materials and huge investments. A simple solution is necessary to make Deep UV lithography a viable manufacturing tool.

## SUMMARY OF THE INVENTION

The present invention relates to a multi-component, high contrast, high sensitivity and high resolution positive photoresist which can be exposed by ultraviolet light, particularly in the wavelength region from 200 nm to 350 nm, without the formation of T-tops, which has been a reputed problem with positive Deep UV photoresists. In addition, such photoresists provide films with much improved adhesion, improved dissolution characteristics, improved resistance to film lifting and the substantial decrease of pit formation.

The formation of "channels" or "T-tops" is typical with t-butoxycarbonyl ("t-boc") protected polymer systems utilized in Deep UV photoresists. The formation of the surface skin which leads to the formation of T-tops is believed to result from the interaction of these polymer systems with airborne contaminants. The surface skin

which results is insoluble in aqueous base developers. It has been proposed to process wafers in a chamber wherein the cleanroom air is further filtered or to provide a protective overcoat to separate the surface of the photoresist film from the environment.

The present invention provides a much simpler solution to this problem by providing a class of organic additives which are added to the photoresist formulation. These organic additives have the following structural formula:

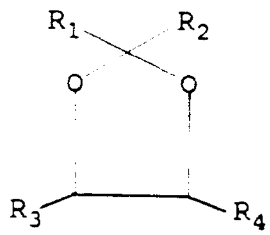

wherein $R_1$ and $R_2$ are phenyl, substituted phenyl or alkyl ($C_NH_{2N+1}$) where N is preferably 1, 2 or 3; $R_3$ and $R_4$ are alkyl ($C_NH_{2N+1}$), cycloalkyl preferably having from 4 to 10 carbon atoms, -CN, -$NO_2$, halogen atom, -$CX_3$ (where X is a halogen atom), -$SO_3$-$R_5$ (where $R_5$ is H, -$CX_3$, -$PO_3$,

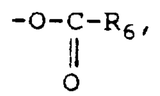

where $R_5$ is alkyl ($C_NH_{2N+1}$) phenyl, naphthyl, anthryl or anthryl substituted with one or more of the $R_3$, $R_4$ or $R_5$ groups),

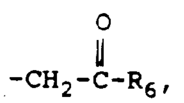 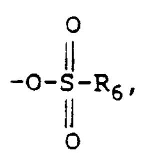 $-O-R_6$, 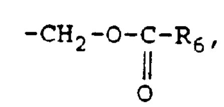

-$CH_2$-OTs (where OTs is

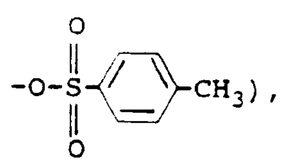 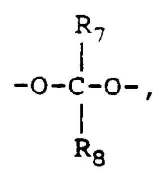 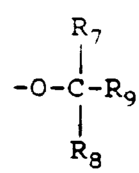

(where $R_7$, $R_8$ and $R_9$ can be any of the $R_3$, $R_4$ or $R_5$ groups.
$R_3$ and $R_4$ can also be part of the cyclic structure -(CR')N- where N is from 1 to 8 and R' is H or any of the $R_3$, $R_4$ or $R_5$ groups.

DESCRIPTION OF THE PREFERRED EMBODIMENTS

Preferably the organic additives are acetal or ketal derivatives such as 1,4-Di-O-tosyl-2,3-O-isopropylidene-L-threitol; oligoacetal; diacetone-D-glucose; or 3-O-acetyl-6-O-benzoyl-5-O-(methyl sulfonyl)-1,2-O-isopropylidene-alpha-D-glucofuranose. Other preferred additives include 1,2,3,4-Di-O-isopropylidene-6-O-(tolysulfonyl)-alpha-D-galactopyranose; 1,2,5,6-Di-O-isopropylidene-3-O-(para-tolylsulfonyl)-alpha-D-allofuranose; 1,2-O-isopropylidene-6-O-(para-tolylsulfonyl)-beta-L-ido-furanose, 2,2'-di-methyl-1,3-dioxolane-4-methanol and N-O acetals having the following structural formula:

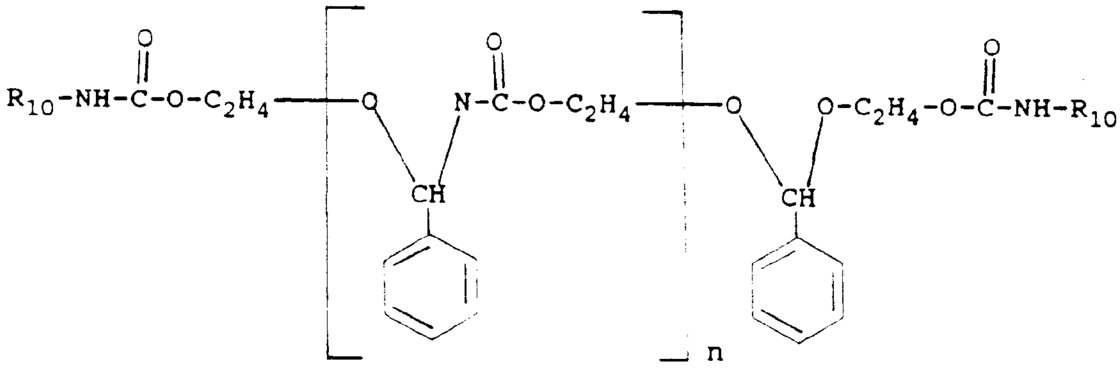

where n equals 1 to 15 and $R_{10}$ is alkyl ($C_NH_{2N+1}$).

Preferably the photoresist formulation contains a protected polymer (e.g. with a t-boc or other protecting group), such as a polystyrene(t-butoxycarbonyl)maleimide, a poly(t-butoxycarbonyl hydroxystyrene) or a poly(t-butoxycarbonyl-hydroxystyrene-sulfur dioxide). In addition, the formulation also preferably contains an organic or inorganic photoacid generator.

The latent photoacid may be selected from a wide range of substances known to form acids upon irradiation including diazoketones, such as diazonaphthoquinones

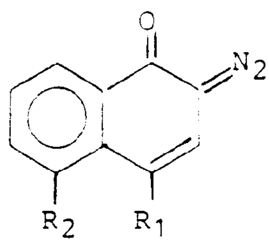

barbituric acid or 5-diazobarbituric acid derivatives, such as

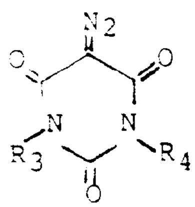

where $R_1$ and $R_2$ are either sulfonyl moieties

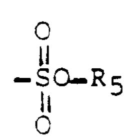

or H (but not the same) and $R_3$, $R_4$ and $R_5$ are alkyl or aryl groups. Additionally, "onium" salts such as diazonium, iodonium or sulfonium salts may be used as the photoacids in this invention, e.g.,

$$R_6N_2^+Y^-,\ (R_6)_2I^+Y^-,\ (R_6)_3S^+Y^-$$

where $R_6$ is phenyl or substituted aryl. The choice of gegenion, $Y^-$, may be made from a wide range of anionic species. However, properties such as the marginal stability of, e.g., onium bisulfate or chloride salts and the potential hazards of, e.g., arsenic, phosphorous, boron, or antimony to the integrity of the circuits being fabricated, cause anions such as $HSO_4^-$, $Cl^-$, $BF_4^-$, $PF_6^-$, $AsF_6^-$, or $SbF_6^-$ to be less desirable than anions such as triflate ($CF_3SO_3^-$) or methane sulfonate or, generally $RSO_3^-$ where R is alkyl, aryl, or substituted alkyl or aryl.

The principal characteristic of the gegenion is, however, that it be the conjugate base of a strong acid so that the equilibrium

$$H^+ + Y^- = HY$$

will be such that the protons generated by exposure and subsequent reaction of the onium salt are not "consumed" to give primarily HY but remain available to attack the acid labile blocking group.

Among the preferred latent photoacids are diphenyl iodonium triflate, triphenylsulfonium hexafluoroantimonate, diphenyl iodonium hexafluorophosphate, phenylacylsulfonium hexafluoroantimonate, or other organic PAG's including those having the following structural formulas:

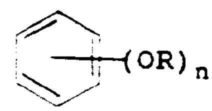

where n = 1-4, R = $-SO_2-CX_3$ $-SO_2-CH_3$ and x=halogen;

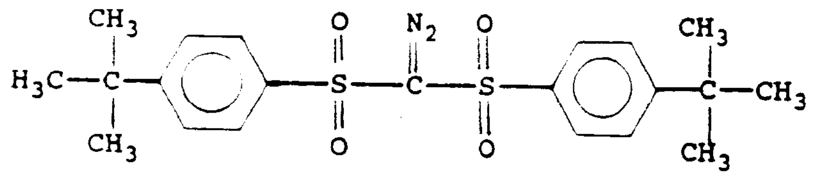

;

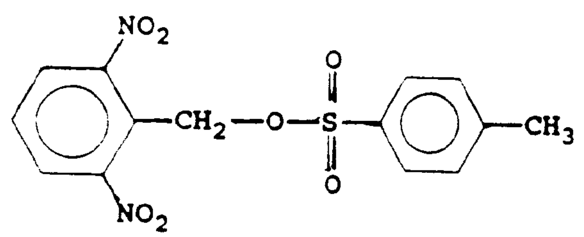

.

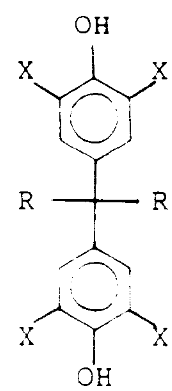

R = Alkyl groups ($C_nH_{2n+1}$ where n = 1-3) or H; X = Halogen;

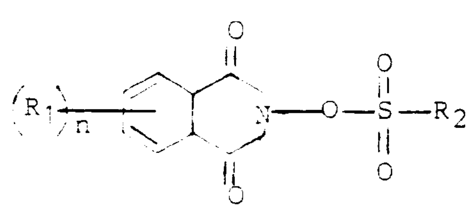

$R_1$ = $NO_2$, -CN, Halogen; $R_2$ = $CX_3$ where X = Halogen, alkyl ($C_nH_{2n+1}$ where n = 1-2);

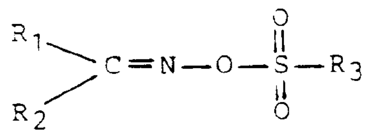

$R_1$ and $R_2$ = Alkyl groups ($C_nH_{2n+1}$) wherein at least one -H is replaced by : -CN, $NO_2$, Halogen or part of a cyclic ring;

$R_3$ = $CX_3$ where X = Halogen or H.

The present invention provides a positive photoresist composition consisting essentially of an admixture of:

a) 1 to 25% of a latent photoacid;

b) 10 to 40% of a film forming polymer;

c) 1 to 40% of an organic additive having the following structural formula:

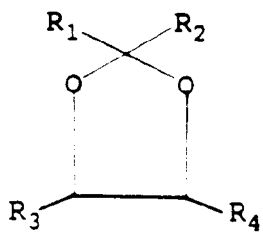

wherein $R_1$ and $R_2$ are phenyl, substituted phenyl or alkyl ($C_NH_{2N+1}$) where N is preferably 1, 2 or 3; $R_3$ and $R_4$ are alkyl ($C_NH_{2N+1}$), cycloalkyl preferably having from 4 to 10 carbon atoms, -CN, -$NO_2$, halogen atom, -$CX_3$ (where X is a halogen atom), -$SO_3$-$R_5$ (where $R_5$ is H, -$CX_3$, -$PO_3$,

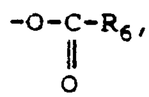

where $R_6$ is alkyl ($C_NH_{2N+1}$) phenyl, naphthyl, anthryl or anthryl substituted with one or more of the $R_3$, $R_4$ or $R_5$ groups),

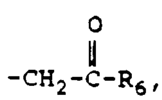 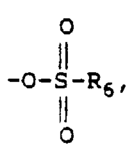 -O-$R_6$, 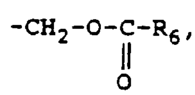

-$CH_2$-OTs (-where OTs is

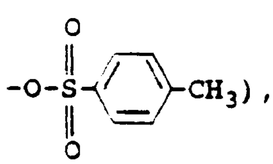 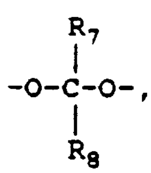 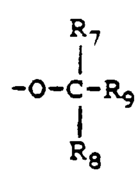

(where $R_7$, $R_8$ and $R_9$ can be any of the $R_3$, $R_4$ or $R_5$ groups.

d) a suitable solvent.

The latent photoacid is preferably an iodonium salt or a sulfonium salt, most preferably a phenyl iodonium salt or a phenyl sulfonium salt. The film forming polymer is preferably an imide polymer or a hydroxystyrene polymer. The polyimide preferably has from about 5% to about 98% of its imide groups blocked by acid labile groups. The most preferably film forming is a poly(maleimide-co-styrene). The hydroxystyrene polymer preferably has from about 5% to about 98% of its hydroxystyrene groups blocked by acid labile groups. The most preferred hydroxystyrene polymers are a poly(hydroxystyrene) or a poly(hydroxystyrene-sulfur dioxide).

The acid labile group is preferably an oxycarbonyl group, most preferably a t-butoxy carbonyl group. The preferred organic additive is an acetal or ketal, most preferably selected from the group consisting of 1,4-Di-O-tosyl-2,3-O-isopropylidene-L-threitol; oligoacetal; diacetone-O-glucose; or 3-O-acetyl-6-O-benzoyl-5-O-(methyl sulfonyl)-1,2-O-isopropylidene-alpha-D-glucofuranose. Other preferred additives include 1,2,3,4-Di-O-isopropylidene-6-O-(toly-sulfonyl)-alpha-D-galactopyranose; 1,2,5,6-Di-O-isopropylidene-3-O-(para-tolylsulfonyl)-alpha-D-allofuranose; 1,2-O-isopropylidene-6-O-(para-tolylsulfonyl)-beta-L-ido-furanose, 2,2′-dimethyl-1,3-dioxolane-4-methanol and N-O acetals having the following structural formula:

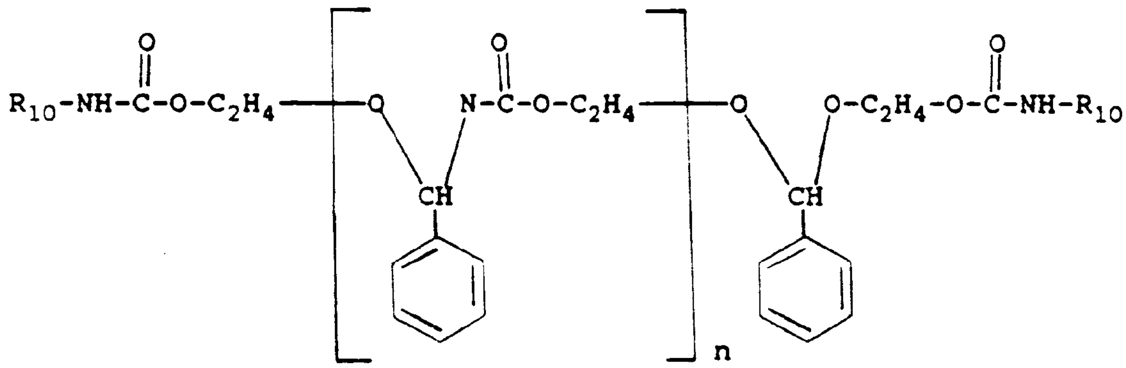

where n equals 1 to 15 and $R_{10}$ is alkyl ($C_NH_{2N+1}$).

The present invention also provides a method for producing a semiconductor device by producing a photoresist image on a substrate by coating a suitable substrate with a positive working photoresist composition, which composition consists essentially of an admixture of:

a) 1 to 25% of a latent photoacid;

b) 10 to 40% of a film forming polymer;

c) 1 to 40% of an organic additive having the following structural formula:

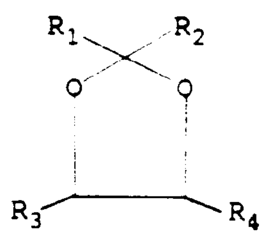

wherein $R_1$ and $R_2$ are phenyl, substituted phenyl or alkyl ($C_NH_{2N+1}$) where N is preferably 1, 2 or 3; $R_3$ and $R_4$ are alkyl ($C_NH_{2N+1}$), cycloalkyl preferably having from 4 to 10 carbon atoms, -CN, $-NO_2$, halogen atom, $-CX_3$ (where X is a halogen atom), $-SO_3-R_5$ (where $R_5$ is H, $-CX_3$, $-PO_3$,

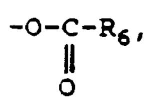

where $R_6$ is alkyl ($C_NH_{2N+1}$) phenyl, naphthyl, anthryl or anthryl substituted with one or more of the $R_3$, $R_4$ or $R_5$ groups),

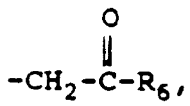, 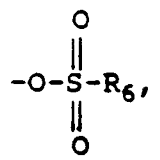, $-O-R_6$, 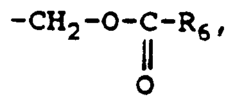,

$-CH_2-OTs$ (where OTs is

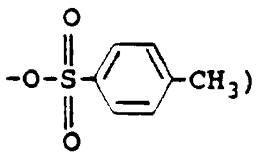), 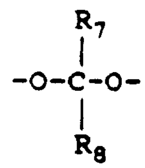, 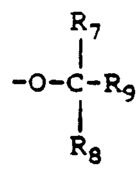

(where $R_7$, $R_8$ and $R_9$ can be any of the $R_3$, $R_4$ or $R_5$ groups.

d) a suitable solvent.

e) the coated substrate is preferably heat treated until substantially all of the solvent is removed; image-wise exposing the photosensitive composition; and removing the image-wise exposed areas of such composition with an aqeuous alkaline developer. Optionally one may perform a baking of the substrate either immediately before or after the removing step.

The latent photoacid is preferably an iodonium salt or a sulfonium salt and most preferably a phenyl iodonium salt or a pheny sulfonium salt. The film forming polymer is preferably an imide polymer or a hydroxystyrene polymer. The polyimide preferably has from about 5% to about 98% of its imide groups blocked by acid labile groups. The most preferable forming polyimide is a poly(maleimide-co-styrene). The hydroxystyrene polymer preferably has from about 5% to about 98% of its hydroxystyrene groups blocked by acid labile groups. 'The hydroxystyrene polymers are a poly(hydroxystyrene) or a poly(hydroxystyrene-sulfur dioxide).

The preferred acid labile group is an oxycarbonyl group most preferably a t-butoxy carbonyl group. The preferred organic additive is an acetal or ketal, most preferably selected from the group consisting of 1,4-Di-O-tosyl-2,3-O-isopropylidene-L-threitol; oligoacetal; diacetone-D-glucose; or 3-O-acetyl-6-O-benzoyl-5-O-(methyl sulfonyl)-1,2-O-isopropylidene-alpha-D-glucofuranose. Other preferred additives include 1,2,3,4-Di-O-isopropylidene-6-O-(toly-sulfonyl)-alpha-D-galactopyranose; 1,2,5,6-Di-O-isopropylidene-3-O-(para-tolylsulfonyl)-alpha-D-allofuranose; 1,2-O-isopropylidene-6-O-(para-tolylsulfonyl)-beta-L-ido-furanose, 2,2'-dimethyl-1,3-dioxolane-4-methanol and N-O acetals having the following structural formula:

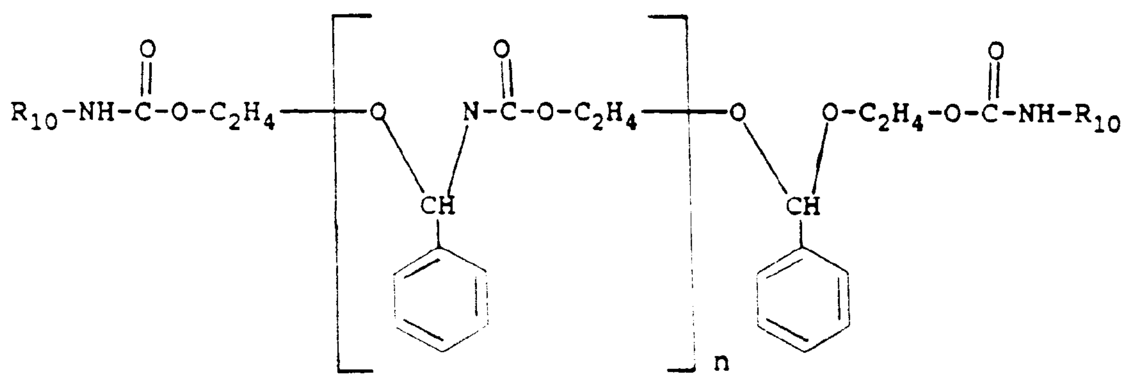

where n equals 1 to 15 and $R_{10}$ is alkyl ($C_NH_{2N+1}$).

The photoresist composition is formed by blending the ingredients in a suitable solvent. In the preferred embodiment, the amount of film forming polymer in the photoresist preferably ranges from 10% to about 40% and more preferably from about 20% to about 30% based on the weight of the solid; i.e., non-solvent photoresist components. In the preferred embodiment, the latent photoacid is present in the photoresist in an amount of from about 1% to about 25%, most preferably from about 8% to about 20%, based on the weight of the solid photoresist components. Preferably, the organic additive is present in the photoresist in an amount of from about 1% to about 25%, most preferably from about 3% to about 15%, based on the weight of the solid photoresist components. In producing the photoresist composition, the latent photoacid, film forming polymer and organic

additive are mixed with such solvents as propylene glycol mono-alkyl ether, propylene glycol alkyl ether acetate, butyl acetate, xylene, ethylene glycol monoethyl ether acetate, and most preferably diglyme, among others. The solvent is preferably present in an amount of from 30% to about 95%, most preferably from about 50% to about 75%, based on the weight of the solid photoresist components.

Other optional ingredients such as colorants, dyes, anti-striation agents, leveling agents, plasticizers, adhesion promoters, speed enhancers, solvents and such surfactants as non-ionic surfactants may be added to the solution of resin, sensitizer and solvent before the solution is coated onto a substrate. Examples of dye additives that may be used together with the photoresist compositions of the present invention include Methyl Violet 2B (C.I. No. 42535), Crystal Violet (C.I. 42555). Malachite Green (C.I. No. 42000), Victoria Blue B (C.I. No. 44045) and Neutral Red (C.I. No. 50040) at one to ten percent weight levels, based on the combined weight of resin and sensitizer. The dye additives help provide increased resolution by inhibiting back scattering of light off the substrate.

Anti-striation agents may be used at up to about a five percent weight level, based on the combined weight of latent photoacid, film forming polymer and organic additive. Plasticizers which may be used include, for example, phosphoric acid tri-(beta-chloroethyl)-ester; dicamphor; polypropylene; acetal resins; phenoxy resins; and alkyl resins, at about one to ten percent weight levels, based on the combined weight of resin and sensitizer. The plasticizer additives improve the coating properties of the material and enable the application of a film that is smooth and of uniform thickness to the substrate.

Adhesion promoters which may be used include, for example, beta-(3,4-epoxy-cyclohexyl)-ethyltrimethoxysilane; p-methyl-disilane-methyl methacrylate; vinyltrichlorosilane; and gamma-amino-propyl triethoxysilane up to about a 4 percent weight level, based on the combined weight of latent photoacid, film forming polymer and organic additive.

The coating solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to about 10% weight levels, based on the combined weight of latent photoacid, film forming polymer and organic additive.

The prepared photoresist solution, can be applied to a substrate by any conventional method used in the photoresist art, including dipping, spraying, whirling and spin coating. When spin coating, for example, the resist solution can be adjusted with respect to the percentage of solids content, in order to provide coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexa-alkyl disilazane.

The photoresist composition solution is then coated onto the substrate, and the substrate is treated at a temperature from about 70°C to about 110°C for from about 30 seconds to about 180 seconds on a hot plate or for from about 15 to about 90 minutes in a convection oven. This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the temperature is from about 85°C to about 95°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist is then optionally subjected to a post exposure second baking or heat treatment either before or after development. The heating temperatures may range from about 90°C to about 120°C, more preferably from about 100°C to about 110°C. The heating may be conducted for from about 30 seconds to about 2 minutes, more preferably from about 60 seconds to about 90 seconds on a hot plate or about 30 to about 45 minutes by convection oven.

The exposed photoresist-coated substrates are developed to remove the image-wise exposed areas by immersion in an alkaline developing solution. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point.

The following specific examples will provide detailed illustrations of the methods of producing and utilizing compositions of the present invention. These examples are not intended, however, to limit or restrict the scope of the invention in any way and should not be construed as providing conditions, parameters of values which must be utilized exclusively in order to practice the present invention.

## Example 1

### Synthesis of Poly(Styrene-co-Maleimide)

Into a one liter jacketed flask fitted with overhead stirrer, thermometer and condenser, were charged 75.0 grams (0.772 moles) maleimide (purchased from Aldrich), 80.47 grams (0.772 moles) styrene (purchased from Fisher) and 625 ml. diglyme as solvent. The reaction mixture was warmed to 35°C and 5.00 ml. of dodecanethiol was added. The reaction mixture was purged with nitrogen and 0.500 grams azoisobutyronitrile (AIBN) was added as an initiator for polymerization. The reaction mixture was heated to 60°C and was held at that temperature for two hours. 500 mg. of additional AIBN was added and the reaction mixture was stirred for 10 hours and 60°C.

The reaction mixture was cooled to 15°C and was drowned in 5 liters of methanol and the precipitate was stirred for 15 minutes. The mixture was filtered and the crude was washed with 2.5 liters of methanol.

The crude was redissolved in 500 ml. THF. The solution was filtered through an F-3 pad and was washed with 100 ml. THF. The solution was drowned into 5 liters of methanol; the precipitated polymer was filtered and then washed with an additional two liter methanol. The purified polymer was dried.

## Example 2

### Synthesis of N(t-butyl carbonyl) Poly(Styrene-co-Maleimide)

Into a two liter jacketed flask fitted with overhead stirrer, thermometer and nitrogen inlet, were charged 80.0 grams (0.4 moles) of Poly(Styrene-co-Maleimide) (1:1) and 800 ml. THF as solvent. The polymer was dissolved by stirring at room temperature for about 45 minutes. The solution was cooled to -7°C in an ice-acetone mixture bath. 54.0 grams (0.48 mole) of dimethylaminopyridine (DMAP) was added to the reaction mixture under stirring. At this stage, 102.0 grams (0.467 mole) N(di-t-butylcarbonate) was added to the reaction mixture by maintaining a temperature of 5°C. The ice-bath was removed and the reaction mixture was heated with a thermowatch to 30°C for 8 hours.

4 liters of deionized water, 4 liters of methanol and 52.8 grams glacial acetic acid were placed in a battery jar. The reaction mixture (yellow to brown) was placed in a dropping funnel. Overhead stirring was used to stir the solution. The reaction mixture was added to the deionized water-methanol mixture gradually over a period of one hour. A yellowish brown fine precipitate was obtained at this stage which was stirred for about two hours, then decanted for half hour and filtered. The fine polymer was washed using 16 liters of deionized water. The purified polymer was dried overnight using vacuum and finally in a vacuum oven at 60°C.

The polymer obtained had the following characteristics:

- $M_w$ 15-25,000
- $M_n$ 10-12,000
- D = 1.43
- Tg = 246°C
- 59% transparency at 248 nm
- % t-boc capping is 98%

Comparative Example 3

Photosensitive Formulation without any Additive

2.6 grams solid N(t-boc) Poly(Styrene-co-Maleimide) and 0.43 grams diphenyl iodonium triflate were dissolved in 7.4 grams diglyme at room temperature by stirring. The solution was filtered through 0.2 micron PTFE filters. The filtered solution 'was coated to an approximate thickness of one micron on a silicon wafer previously treated with hexamethyldisilazane (HMDS). The coated wafer was baked on a hot plate at 90°C for 60 seconds and was exposed to 248 nm light through a submicron resolution mask. The exposed wafer was further baked on a hot plate at 110°C for 60 seconds and developed in an alkaline metal ion free developer (AZ312MIF available from Hoechst Celanese Corporation) to show submicron resolution. However, SEM pictures reveal presence of hang over profiles between the line-space (1/s) pair at the submicron levels.

Example 4

Photosensitive Formulation with Additive

2.6 grams solid N-(t-boc) Poly(Styrene-co-Maleimide), 0.43 grams diphenyl iodonium triflate and 0.22 grams 1,4-Di-o-tosyl-2,3-o-isopropylidene-L-threitol were dissolved in 7.4 grams diglyme. The solution was filtered through 0.2 micron teflon filter. The filtered solution was spin coated on a silicon wafer to approximately one micron thickness, baked on a hot plate at 90°C for 60 seconds to remove solvent and imagewise exposed to 248 nm light source. The exposed wafer was baked on a hot plate at 110°C for 60 seconds and developed with metal ion free developer (0.075 N) for 120 seconds to obtain submicron resolution. SEM pictures reveal absence of any hang over profiles between the line/space profiles.

Example 5

Photosensitive Formulation with Additive

7.9 grams solid N-(t-boc) Poly(Styrene-co-Maleimide), 1.303 grams triphenylsulfonium hexafluoroantimonate and 0.33 grams diacetone glucose were dissolved in 22.46 grams diglyme. The solution was filtered through 0.2 micron teflon filter. The filtered solution was spin coated on a silicon wafer to approximately one micron thickness and the coated wafer was baked on a hot plate at 90°C for 60 seconds to remove solvent and form a uniform film. The wafer was imagewise exposed to a 248 nm light source and baked again at 110°C for 60 seconds on a hot plate. Upon development of the wafer with metal ion free developer the exposed areas developed out to give a positive image with submicron resolution. SEM pictures revealed absence of any hang over profiles between the lines and space pairs even at the submicron regime.

Example 6

Photosensitive Formulation with Additive

5.2 grams solid N-(t-boc) Poly(Styrene-co-Maleimide) polymer, 0.858 grams diphenyl iodonium triflate and 0.442 grams of an N-O oligoacetal were dissolved in 14.8 grams diglyme. The solution was filtered through a 0.2 micron teflon filter. The filtered solution was spin coated on a silicon wafer to an approximate thickness of one micron; baked on a hot plate at 90°C for 60 seconds to remove solvent. The coated wafer was exposed imagewise to a 248 nm light source and baked on a hot plate at 110°C for 60 seconds. Between exposure and post exposure bake the waiting period could be anywhere between one minute to 30 minutes or longer. The post exposed baked wafer was developed with MIF developer to remove the exposed areas to generate a scum free positive image with submicron resolution without the presence of any hang over profiles or T-tops.

Example 7

Photosensitive Formulation without any Additive

5.2 grams solid t-boc protected poly(hydroxy styrene) (19% degree of protection) and 0.858 grams diphenyl iodonium triflate were dissolved in 14.8 grams diglyme. The solution was filtered through a teflon filter. The filtered solution was spin coated on a silicon wafer (HMDS coated) to a thickness of approximately one micron

and baked on a hot plate at 90°C for 60 seconds to remove solvent. The wafer was exposed imagewise to a 248 nm light source and further baked on a hot plate at 110°C for 60 seconds when developed with MIF developer, severe film lifting and "pit" formation due to lack of proper adhesion was observed under SEM. No descent 1/s resolution could be achieved even for larger line widths.

Example 8

Photosensitive Formulation with Additive

5.2 grams solid t-boc protected poly(hydroxy-styrene) (degree of protection = 19%), 0.858 grams diphenyl iodonium triflate and 0.442 grams 1,4-Di-o-tosyl-2,3-o-isopropylidene threitol were dissolved in 14.8 grams diglyme. The solution was filtered through a teflon filter and was spin coated on silicon wafer (HMDS treated) to a thickness of approximately one micron. The coated wafer was baked on a hot plate at 90°C for 60 seconds and was imagewise exposed to a 248 nm light source. The exposed wafer was further baked on a hot plate at 110°C for 60 seconds. Lithographic images were obtained upon development of the exposed areas with an MIF developer. Adhesion characteristics of the film was found to be much improved in presence of additive compared to in absence of it. Film lifting and "pit" formation was found to be dramatically improved by the presence of the additive.

It will of course be understood that the present invention has been described above purely by way of example and that modifications of detail can be made within the scope of the invention.

The dependencies of the subsidiary claims hereinafter do not imply any limitation as to the possible combinations of the features mentioned in those claims.

## Claims

**1.** A positive photoresist composition consisting essentially of an admixture of:

a) 1 to 25% of a latent photoacid;

b) 10 to 40% of a film forming polymer;

c) 1 to 40% of an organic additive having the following structural formula:

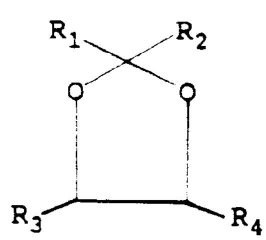

wherein $R_1$ and $R_2$ are phenyl, substituted phenyl or alkyl ($C_NH_{2N+1}$) where N is preferably 1, 2 or 3; $R_3$ and $R_4$ are alkyl ($C_NH_{2N+1}$), cycloalkyl preferably having from 4 to 10 carbon atoms, -CN, $-NO_2$, halogen atom, $-CX_3$ (where X is a halogen atom), $-SO_3-R_5$ (where $R_5$ is H, $-CX_3$, $-PO_3$,

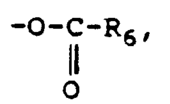

where $R_6$ is alkyl ($C_NH_{2N+1}$) phenyl, naphthyl, anthryl or anthryl substituted with one or more of the $R_3$, $R_4$ or $R_5$ groups),

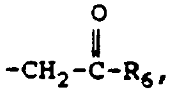, 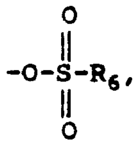, $-O-R_6$, 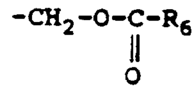,

$-CH_2$-OTs (where OTs is

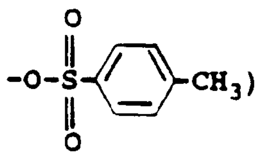, 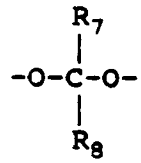, 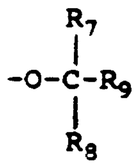

(where $R_7$, $R_8$ and $R_9$ can be any of the $R_3$, $R_4$ or $R_5$ groups.
d) a suitable solvent.

2. The photoresist composition of claim 1 wherein said latent photoacid is an iodonium salt or a sulfonium salt.

3. The photoresist composition of claim 1 wherein said latent photoacid is a phenyl iodonium salt or a phenyl sulfonium salt.

4. The photoresist composition of claim 1 wherein said film forming polymer is an imide polymer or a hydroxystyrene polymer.

5. The photoresist composition of claim 1 wherein said film forming polymer is a polyimide having from about 5% to about 98% of its imide groups blocked by acid labile groups.

6. The photoresist composition of claim 5 wherein said film forming polymer is poly(maleimide-co-styrene).

7. The photoresist composition of claim 1 wherein said film forming polymer is a hydroxystyrene polymer having from about 5% to about 98% of its hydroxystyrene groups blocked by acid labile groups.

8. The photoresist composition of claim 7 wherein said film forming polymer is a poly(hydroxystyrene) or a poly(hydroxystyrene-sulfur dioxide).

9. The photoresist composition of claim 7 wherein said acid labile group is an oxycarbonyl group.

10. The photoresist composition of claim 9 wherein said acid labile group is a t-butoxy carbonyl group.

11. The photoresist composition of claim 1 wherein said organic additive is an acetal or ketal.

12. The photoresist composition of claim 1 wherein said organic additive is selected from the group consisting of 1,4-Di-O-tosyl-2,3-O-isopropylidene-L-threitol; oligoacetal; diacetone-D-glucose; or 3-O-acetyl-6-O-benzoyl-5-O-(methyl sulfonyl)-1,2-O-isopropylidene-alpha-D-glucofuranose. Other preferred additives include 1,2,3,4-Di-O-isopropylidene-6-O-(toly-sulfonyl)-alpha-D-galactopyranose; 1,2,5,6-Di-O-isopropylidene-3-O-(para-tolylsulfonyl)-alpha-D-allofuranose; 1,2-O-isopropylidene-6-O-(para-tolylsulfonyl)-beta-L-ido-furanose, 2,2′-di-methyl-1,3-dioxolane-4-methanol and N-O acetals having the following structural formula:

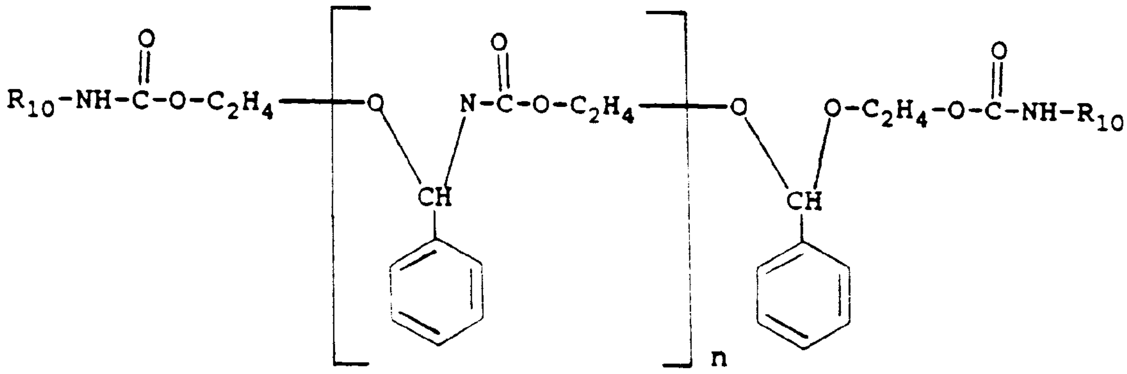

where n equals 1 to 15 and $R_{10}$ is alkyl ($C_NH_{2N+1}$).

**13.** The photoresist composition of claim 1 wherein said solvent is selected from the group consisting of propylene glycol mono-alkyl ether, propylene glycol alkyl ether acetate, butyl acetate, xylene, ethylene glycol monoethyl ether acetate and diglyme.

**14.** The photoresist composition of claim 1 wherein said solvent is dyglyme.

**15.** A method for producing a semiconductor device by producing a photoresist image on a substrate by coating a suitable substrate with a positive working photoresist composition, which composition consists essentially of an admixture of:

a) 1 to 25% of a latent photoacid;
b) 10 to 40% of a film forming polymer;
c) 1 to 40% of an organic additive having the following structural formula:

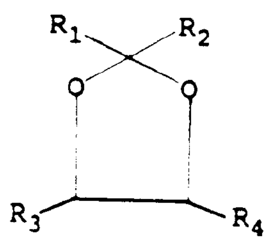

wherein $R_1$ and $R_2$ are phenyl, substituted phenyl or alkyl ($C_NH_{2N+1}$) where N is preferably 1, 2 or 3; $R_3$ and $R_4$ are alkyl ($C_NH_{2N+1}$), cycloalkyl preferably having from 4 to 10 carbon atoms, -CN, $-NO_2$, halogen atom, $-CX_3$ (where X is a halogen atom), $-SO_3-R_5$ (where $R_5$ is H, $-CX_3$, $-PO_3$,

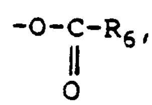

where $R_6$ is alkyl ($C_NH_{2N+1}$) phenyl, naphthyl, anthryl or anthryl substituted with one or more of the $R_3$, $R_4$ or $R_5$ groups),

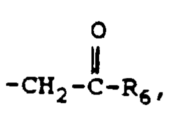 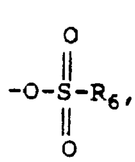 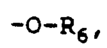 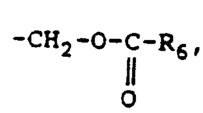

$-CH_2-OTs$ (where OTs is

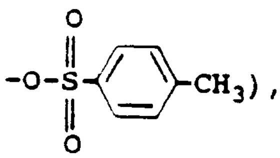
,
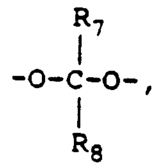
,
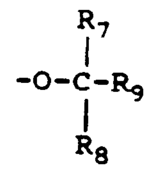

(where $R_7$, $R_8$ and $R_9$ can be any of the $R_3$, $R_4$ or $R_5$ groups.
d) a suitable solvent.

**16.** The method of claim 15 wherein said latent photoacid is an iodonium salt or a sulfonium salt.

**17.** The method of claim 15 wherein said latent photoacid is a phenyl iodonium salt or a phenyl sulfonium salt.

**18.** The method of claim 15 wherein said film forming polymer is an imide polymer or a hydroxystyrene polymer.

**19.** The method of claim 15 wherein said film forming polymer is a polymimide having from about 5% to about 98% of its imide groups blocked by acid labile groups.

**20.** The method of claim 19 wherein said film forming polymer is poly(maleimide-co-styrene).

**21.** The method of claim 15 wherein said film forming polymer is a hydroxystyrene polymer having from about 5% to about 98% of its hydroxystyrene groups blocked by acid labile groups.

**22.** The method of claim 21 wherein said film forming polymer is a poly(hydroxystyrene) or a poly(hydroxystyrene-sulfur dioxide).

**23.** The method of claim 21 wherein said acid labile group is an oxycarbonyl group.

**24.** The method of claim 23 wherein said acid labile group is a t-butoxy carbonyl group.

**25.** The method of claim 15 wherein said organic additive is an acetal or ketal.

**26.** The method of claim 15 wherein said organic additive is selected from the group consisting of 1,4-Di-O-tosyl-2,3-O-isopropylidene-L-threitol; oligoacetal; diacetone-D-glucose; or 3-O-acetyl-6-O-benzoyl-5-O-(methyl sulfonyl)-1,2-O-isopropylidene-alpha-D-glucofuranose. Other preferred additives include 1,2,3,4-Di-O-isopropylidene-6-O-(toly-sulfonyl)-alpha-D-galactopyranose; 1,2,5,6-Di-O-isopropylidene-3-O-(para-tolylsulfonyl)-alpha-D-allofuranose; 1,2-O-isopropylidene-6-O-(para-tolylsulfonyl)-beta-L-ido-furanose, 2,2′-di-methyl-1,3-dioxolane-4-methanol and an acetal having the following structural formula:

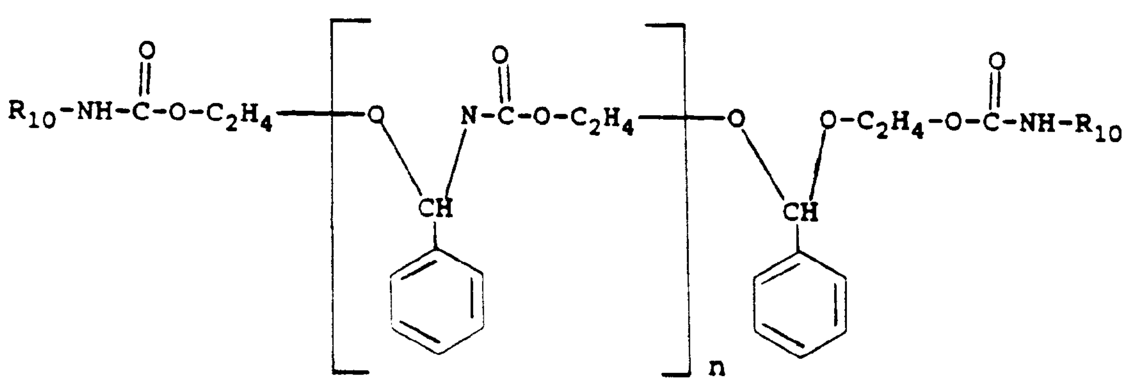

where n equals 1 to 15 and $R_{10}$ is alkyl ($C_NH_{2N+1}$).

**27.** The method of claim 15 wherein said solvent is selected from the group consisting of propylene glycol

mono-alkyl ether, propylene glycol alkyl ether acetate, butyl acetate, xylene, ethylene glycol monoethyl ether acetate and diglyme.

**28.** The method of claim 15 wherein said solvent is dyglyme.

European Patent Office

# EUROPEAN SEARCH REPORT

Application Number

EP 92 30 5400

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | FR-A-2 305 757 (HOECHST AG)<br>* the whole document *<br>--- | 1 | G03F7/004 |
| A | EP-A-0 031 566 (E.I DU PONT DE NEMOURS AND COMPANY)<br>* the whole document *<br>--- | 1 | |
| A | EP-A-0 361 906 (HOECHST CELANESE CORPORATION)<br>* the whole document *<br>--- | 1 | |
| A | EP-A-0 372 408 (BASF AG)<br>* the whole document *<br>----- | 1 | |
| | | | TECHNICAL FIELDS SEARCHED (Int. Cl.5 ) |
| | | | G03F |

The present search report has been drawn up for all claims

| Place of search | Date of completion of the search | Examiner |
|---|---|---|
| THE HAGUE | 31 AUGUST 1992 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)